# FASCICULE DE BREVET EUROPEEN

(11) **EP 3 381 123 B1**
(45) Date de publication et mention de la délivrance du brevet: **06.05.2020**
(21) Numéro de dépôt: 16819966.9
(22) Date de dépôt: 25.11.2016
(51) Int. Cl.: H03F 1/02, H03F 3/21, H03F 3/193, H02M 1/08

(54) **BLOC CONVERTISSEUR CONTINU-CONTINU A MULTIPLES TENSIONS D'ALIMENTATION, CONVERTISSEUR CONTINU-CONTINU A MULTIPLES TENSIONS D'ALIMENTATION LE COMPRENANT ET SYSTEME DE SUIVI D'ENVELOPPE ASSOCIE**
GLEICHSPANNUNGSWANDLERBLOCK MIT MEHREREN VERSORGUNGSSPANNUNGEN, GLEICHSPANNUNGSWANDLER MIT MEHREREN VERSORGUNGSSPANNUNGEN UND ZUGEHÖRIGES HÜLLKURVENNACHFÜHRUNGSSYSTEM
DC-TO-DC CONVERTER BLOCK WITH MULTIPLE SUPPLY VOLTAGES, MULTI-SUPPLY-VOLTAGE DC-TO-DC CONVERTER COMPRISING SAME, AND ASSOCIATED ENVELOPE TRACKING SYSTEM

(30) Priorité: 27.11.2015 FR 1561447
(43) Date de publication de la demande: 03.10.2018
(73) Titulaire: Wupatec, 87000 Limoges (FR)
(72) Inventeur: GATARD, Emmanuel, 87350 Panazol (FR); LACHAUD, Pierre, 87590 Saint Just Le Martel (FR)
(74) Mandataire: Cabinet Chaillot
(86) Numéro de dépôt international: PCT/FR2016/053098
(87) Numéro de publication internationale: WO 2017/089726

(56) Documents cités:
- US-B2- 9 106 184
- PABLO F MIAJA ET AL: "Enhancements of the multiple input buck converter used for Envelope Tracking applications by improved output filter design and multiphase operation", ENERGY CONVERSION CONGRESS AND EXPOSITION (ECCE), 2012 IEEE, IEEE, 15 septembre 2012 (2012-09-15), pages 1841-1848, XP032467403, DOI: 10.1109/ECCE.2012.6342588 ISBN: 978-1-4673-0802-1
- SHINTARO SHINJO ET AL: "High speed, high analog bandwidth buck converter using GaN HEMTs for envelope tracking power amplifier applications", WIRELESS SENSORS AND SENSOR NETWORKS (WISNET), 2013 IEEE TOPICAL CONFERENCE ON, IEEE, 20 janvier 2013 (2013-01-20), pages 13-15, XP032351233, DOI: 10.1109/WISNET.2013.6488618 ISBN: 978-1-4673-3104-3
- HAN PENG ET AL: "100 MHz, 85% efficient integrated AlGaAs/GaAs supply modulator for RF power amplifier modules", APPLIED POWER ELECTRONICS CONFERENCE AND EXPOSITION (APEC), 2013 TWENTY-EIGHTH ANNUAL IEEE, IEEE, 17 mars 2013 (2013-03-17), pages 672-678, XP032410409, DOI: 10.1109/APEC.2013.6520282 ISBN: 978-1-4673-4354-1
- HAN PENG ET AL: "A 150MHz, 84% efficiency, two phase interleaved DC-DC converter in AlGaAs/GaAs P-HEMT technology for integrated power amplifier modules", RADIO FREQUENCY INTEGRATED CIRCUITS SYMPOSIUM (RFIC), 2010 IEEE, IEEE, PISCATAWAY, NJ, USA, 23 mai 2010 (2010-05-23), pages 259-262, XP031684168, ISBN: 978-1-4244-6240-7

## Description

La présente invention concerne le domaine des convertisseurs continu-continu, et porte en particulier sur un bloc convertisseur continu-continu à multiples tensions d'alimentation, un convertisseur continu-continu à multiples tensions d'alimentation le comprenant et un système de suivi d'enveloppe associé.

L'augmentation constante des débits de communication sans fil nécessite l'utilisation de modulations complexes à efficacité spectrale élevée telles que l'OFDM (multiplexage par répartition orthogonale de la fréquence), ces modulations présentant des facteurs de crête importants (rapport entre la puissance crête et la puissance moyenne du signal).

Les amplificateurs de puissance RF qui sont alimentés par une tension d'alimentation continue fournissent un rendement maximal uniquement lorsqu'ils travaillent à la compression, c'est-à-dire à la puissance crête du signal à émettre. Cependant, la plupart du temps, l'amplificateur fournit une puissance bien inférieure à sa puissance maximale, proche de la puissance moyenne du signal à émettre, le rendement de l'amplificateur étant dans ces conditions bien inférieur à son rendement maximal.

La technique de suivi d'enveloppe (en anglais, « Envelope Tracking ») est une technique d'alimentation pour améliorer le rendement des amplificateurs de puissance RF, celle-ci remplaçant l'alimentation constante continue de l'amplificateur par une alimentation dynamique continue qui suit l'amplitude du signal RF à émettre. La technique de suivi d'enveloppe permet d'ajuster dynamiquement la tension d'alimentation de l'amplificateur de puissance RF afin que celui-ci fonctionne toujours en compression et donc à son rendement maximal, quel que soit le niveau de puissance de l'enveloppe du signal RF, cette technique permettant pour les formats de modulation modernes d'améliorer significativement le rendement des amplificateurs de puissance RF tout en répondant aux exigences des normes en termes de linéarité.Dans le cas d'un amplificateur de puissance RF à suivi d'enveloppe, la tension d'alimentation est par définition constamment réajustée afin de s'assurer que l'amplificateur fonctionne toujours à la compression et donc à son rendement maximal, quel que soit le niveau de puissance souhaité à l'émission.

La tension d'alimentation d'un amplificateur de puissance RF à suivi d'enveloppe est générée par un convertisseur continu-continu (également appelé modulateur de polarisation) permettant de générer un signal de commande continu large bande, le modulateur de polarisation étant généralement réalisé à partir d'un convertisseur continu-continu dit hybride qui est un compromis entre rendement et linéarité. Le convertisseur continu-continu hybride comprend une partie convertisseur continu-continu à fort rendement en commutation pure fonctionnant à basses fréquences et une partie amplification linéaire permettant de suivre les variations rapides du signal d'enveloppe. La conversion continu-continu à fort rendement s'appuie sur des convertisseurs en commutation pure de type abaisseur de tension (en anglais, « Buck »), amplificateur de tension (en anglais « Boost »), Buck ou Boost multi-phases, ou Buck à multiples entrées d'alimentation (par commutation de tensions d'alimentation). L'amplification linéaire est quant à elle réalisée à partir d'un amplificateur ultra- linéaire fonctionnant en classe « A » ou « AB » principalement. Cependant, la partie amplification linéaire qui présente un faible rendement dégrade fortement le rendement global du convertisseur continu-continu hybride. En outre, plus la bande passante couverte par la partie amplification linéaire est importante, plus le rendement global est impacté par le faible rendement de la partie amplification linéaire.

Une autre technique connue communément utilisée pour générer un signal de commande continu de suivi d'enveloppe s'appuie uniquement sur l'utilisation seule d'un convertisseur continu-continu en commutation pure. Cette technique présente l'avantage d'obtenir des rendements plus élevés mais souvent au détriment de la linéarité et de la bande passante. Ce type de convertisseurs s'appuie sur des architectures de type Buck, Boost, Buck ou Boost multi-phases, ou Buck à multiples entrées d'alimentation. Dans cette configuration, l'utilisation de convertisseurs à multiples entrées d'alimentation de type abaisseur de tension présente l'avantage de diminuer l'ondulation résiduelle en sortie, d'augmenter la bande passante et également de diminuer les pertes par commutation dans les transistors de puissance.

Une technique alternative à la technique de suivi d'enveloppe classique et aux modulateurs de polarisation décrits précédemment consiste à s'appuyer sur la génération d'un signal de suivi d'enveloppe de type multi-niveaux (ou à niveaux discrets). Cette technique a pour but d'appliquer une tension d'alimentation à l'amplificateur RF parmi plusieurs niveaux de tension possibles, ces niveaux de tension étant soit directement appliqués à l'amplificateur RF soit par l'intermédiaire d'un filtre passe-bas ayant pour fonction de maîtriser les temps de montée et de descente entre chaque tension à appliquer à l'amplificateur RF. Ce type de technique est obligatoirement couplé à une technique de pré-distorsion afin de préserver la linéarité globale du système, le nombre de niveaux de tension pouvant par exemple varier de 2 à 16 selon les capacités du convertisseur et le besoin de l'application. Les convertisseurs pour cette technique de suivi d'enveloppe sont de type Buck, Buck multi-niveaux, Boost, Buck ou Boost multi-phases, ou Buck à multiples entrées d'alimentation (par commutation de tensions d'alimentation), les convertisseurs à multiples entrées d'alimentation étant particulièrement adaptés à cette technique de suivi d'enveloppe car leur fonctionnement même consiste à sélectionner une tension d'alimentation parmi les tensions d'alimentation disponibles en entrée du convertisseur et étant donc beaucoup plus rapides pour changer de tension.

Les modulateurs de polarisation pour la technique de suivi d'enveloppe permettant de générer un signal de commande continu large bande ou à niveaux discrets reposent sur des convertisseurs à découpage, c'est-à-dire par commutation de tension, quel que soit le type de modulateur : hybride, à commutation seule ou à sélection de tension d'alimentation.

Les convertisseurs à multiples entrées d'alimentation utilisent des technologies identiques à celles utilisées dans les alimentations à découpage, ces alimentations utilisant des transistors de type MOSFET (transistor à effet de champ métal-oxyde-semi-conducteur) en technologie au silicium qui présentent l'avantage d'être largement éprouvés et d'être disponibles en technologies complémentaires (à canal N ou P), les grilles des transistors MOSFET étant généralement pilotées par des circuits intégrés sur silicium mettant en œuvre la technique de « Bootstrap » (d'amorçage).

Cependant, les transistors MOSFET en technologie au silicium s'avèrent très limités en fréquence de commutation pour des applications de forte puissance. La réponse à cette problématique passe nécessairement par l'utilisation de nouveaux matériaux tels que le nitrure de gallium (GaN). Pour un tel matériau, des transistors à effet de champ de type HEMT (transistor à haute mobilité d'électrons) à enrichissement (normalement ouverts) ou à effet de champ de type HEMT à déplétion (normalement fermés) existent à partir de processus de fabrication différents. Ils permettent d'atteindre des fréquences de fonctionnement plus importantes mais utilisent des dispositifs de pilotage de grille de type « Bootstrap » toujours en technologie au silicium et sont dépendants des performances de ceux-ci. Par ailleurs, l'utilisation de transistors HEMT à déplétion (normalement fermés) conjointement à un dispositif de pilotage de grille de type « Bootstrap » pose un problème évident lors de la phase de démarrage du circuit, le dispositif de pilotage de grille de type « Bootstrap » imposant, dans son principe de fonctionnement, de continuellement commuter les transistors.

Quelle que soit la technique de suivi d'enveloppe et l'architecture du modulateur de polarisation utilisées, l'augmentation croissante des bandes passantes de modulation nécessite de disposer d'alimentations à découpage capables de fonctionner à des fréquences de commutation très élevées, ces fréquences étant bien supérieures à ce que les technologies disponibles de convertisseurs continu-continu peuvent permettre, notamment dans le cas d'applications de forte puissance.

Les fabricants d'alimentations à découpage se tournent donc vers des transistors à effet de champ de type HEMT à enrichissement en technologie GaN pilotés par des dispositifs de pilotage de type « Bootstrap » au silicium, ce type de transistor étant développé spécialement pour les applications de conversion de tension d'alimentation et permettant d'améliorer significativement les performances vis-à-vis des transistors MOSFET au silicium sans pour autant atteindre des bandes passantes suffisantes pour les applications de forte puissance liées à la technique de suivi d'enveloppe, les convertisseurs continu-continu utilisant ce type de transistors étant principalement limités en fréquence de commutation dans un premier temps par leur dispositif de pilotage de type « Bootstrap » et dans un second temps par les performances des transistors HEMT à enrichissement eux-mêmes développés pour des applications de conversion de tension d'alimentation ne nécessitant pas de larges bandes passantes.
Les transistors à effet de champ de type HEMT à déplétion (normalement fermés) en technologie GaN, généralement utilisés pour des applications d'amplification en radiofréquences et hyperfréquences, permettent d'atteindre des fréquences de fonctionnement très élevées même pour de fortes puissances. Cependant, ni les dispositifs de pilotage de grille de type « Bootstrap » au silicium, ni les topologies existantes des convertisseurs continu-continu ne permettent d'utiliser réellement ce type de composant pour des applications de commutation d'alimentations de forte puissance et très hautes fréquences pour la technique de suivi d'enveloppe.

Le brevet américain US9106184B2 divulgue un amplificateur haute fréquence comprenant un circuit de puissance variable à limitation par diode comprenant une pluralité de circuits à limitation par diode ayant chacun une diode, un transistor et une alimentation électrique, l'ensemble des alimentations électriques étant disposées en série, le circuit de puissance étant piloté par un circuit générateur de signal de commande.

La publication « Enhancements of the multiple input buck converter used for Envelope Tracking applications by improved output filter design and multiphase opération » de PABLO F MIAJA ET AL, ENERGY CONVERSION CONGRESS AND EXPOSITION, 2012 IEEE, divulgue un convertisseur continu-continu à mutiples entrées.

La publication « High speed, high analog bandwidth buck converter using GaN HEMTs for envelope tracking power amplifier applications" de SHINTARO SHINJO ET AL, WIRELESS SENSORS AND SENSOR NETWORKS, 2013 IEEE TOPICAL CONFERENCE ON, divulgue un convertisseur continu-continu utilisant des transistors HEMT.

La présente invention vise à résoudre les inconvénients de l'état antérieur de la technique, en proposant un bloc convertisseur continu-continu à multiples tensions d'alimentation forte puissance et hautes fréquences pour la technique de suivi d'enveloppe pour des applications d'amplification radiofréquence et/ou hyperfréquence de forte puissance afin de permettre une rupture technologique concernant la limitation rendement-bande passante imposée par les convertisseurs continu-continu existants qui rendait jusqu'à maintenant la technique de suivi d'enveloppe difficilement applicable pour les applications de forte puissance avec des débits élevés, ledit bloc convertisseur continu-continu à multiples tensions d'alimentation selon la présente invention comprenant un circuit de puissance avec au moins trois transistors HEMT à déplétion et un circuit de pilotage avec des transistors HEMT à déplétion, le circuit de puissance étant alimenté par au moins trois tensions d'alimentation positives et non nulles.

La présente invention propose également un convertisseur continu-continu à multiples tensions d'alimentation pour la technique de suivi d'enveloppe comprenant le bloc convertisseur continu-continu à multiples tensions d'alimentation, et un système pour la technique de suivi d'enveloppe comprenant un convertisseur continu-continu à multiples tensions d'alimentation pour la technique de suivi d'enveloppe selon la présente invention et un amplificateur radiofréquence (RF) de puissance.

La présente invention a donc pour objet un bloc convertisseur continu-continu selon la revendication 1.

Par forte puissance, on entend des puissances supérieures à 1W.

Par hautes fréquences, on entend des fréquences de commutation supérieures à 10MHz.

Ainsi, le bloc convertisseur continu-continu à multiples tensions d'alimentation est spécialement approprié pour la technique de suivi d'enveloppe, les transistors hyperfréquences de type HEMT à déplétion (dits normalement fermés) étant spécifiquement appropriés pour des applications de forte puissance avec des fréquences de commutation élevées.

Différentes technologies de semi-conducteurs peuvent être utilisés pour la réalisation des transistors HEMT à déplétion, ces matériaux étant principalement le nitrure de gallium (GaN) et l'arséniure de gallium (GaAs) mais aussi tout autre matériau semi-conducteur à base de matériaux du groupe III-V tels que AlGaN, AlN, InAlN, InAlGaN, etc.

L'utilisation de transistors RF et hyperfréquence de type HEMT à déplétion offre un fort potentiel en termes de fréquence de fonctionnement de par leurs très faibles capacités parasites, ce type de transistors permettant traditionnellement d'adresser des fonctions d'amplification de puissance jusqu'à plusieurs dizaines de gigahertz, ce type de transistor offrant en outre les avantages d'être disponible suivant différents développements de grille et d'être très facilement intégrable dans des circuits monolithiques MMIC (circuits intégrés monolithiques hyperfréquences).

De plus, les très faibles capacités parasites de ces transistors HEMT à déplétion associées à des tensions de claquage élevées rendent ce type de composants particulièrement adapté aux applications de commutation rapide de forte puissance (> 1W).

Les transistors HEMT à déplétion présentent en outre l'avantage d'être utilisables en conduction directe et inverse. Ils ne nécessitent donc pas nécessairement de diodes Schottky placées en parallèle pour la gestion des courants inverses, ce qui permet de rendre minimales les capacités parasites et donc d'atteindre des fréquences de commutation plus importantes.

Le circuit de pilotage de grille est intégré au bloc convertisseur continu-continu dans la même technologie, c'est-à-dire comprenant des transistors HEMT à déplétion, ce qui permet d'obtenir un circuit de pilotage de grille ultra rapide et à faible consommation.

Le bloc convertisseur continu-continu à multiples tensions d'alimentation permet en outre, par l'intermédiaire du circuit de pilotage piloté par des signaux numériques, la sélection d'une tension d'alimentation unique parmi les N tensions d'alimentation.

Les tensions intermédiaires peuvent être réparties uniformément ou non entre les tensions supérieure et inférieure.

Selon une caractéristique particulière de l'invention, le circuit de puissance comprend un transistor de puissance inférieur HEMT à déplétion et (N-1) transistors de puissance supérieurs HEMT à déplétion, la borne de sortie de conduction du transistor de puissance inférieur étant connectée à la tension d'alimentation inférieure, la borne d'entrée de conduction de l'un des transistors de puissance supérieurs étant connectée à la tension d'alimentation supérieure, les bornes d'entrée de conduction des (N-2) autres transistors de puissance supérieurs étant respectivement connectées aux (N-2) tensions d'alimentation intermédiaires, la sortie du circuit de puissance étant connectée à la borne d'entrée de conduction du transistor de puissance inférieur et aux bornes de sortie de conduction des (N-1) transistors de puissance supérieurs, et les grilles des transistors de puissance inférieur et supérieurs étant connectées au circuit de pilotage du bloc convertisseur continu-continu, de telle sorte que la tension de sortie du circuit de puissance du bloc convertisseur continu-continu est bornée par les tensions d'alimentation inférieure et supérieure.

Les transistors de puissance HEMT peuvent fonctionner en conduction directe (quadrant (V_{ds}, I_{ds}) > 0) ou inverse (quadrant (V_{ds}, I_{ds}) < 0) . En conduction directe, la borne d'entrée de conduction est le drain et la borne de sortie de conduction est la source. En conduction inverse, la borne d'entrée de conduction est la source et la borne de sortie de conduction est le drain.

Le transistor de puissance inférieur HEMT associé à la tension d'alimentation inférieure fonctionne de préférence en conduction inverse, la source dudit transistor de puissance inférieur étant préférablement reliée à la tension d'alimentation inférieure. Il est à noter que les transistors de puissance supérieurs et inférieur peuvent fonctionner soit en conduction directe soit en conduction inverse.

Le dimensionnement des transistors de puissance HEMT peut être différent pour chaque transistor de puissance HEMT en fonction des tensions d'alimentation présentées à ceux-ci.

Le bloc convertisseur continu-continu à multiples tensions d'alimentation permet, par l'intermédiaire du circuit de pilotage, la sélection en tant que tension de sortie d'une tension d'alimentation parmi les N tensions d'alimentation, ladite tension de sortie étant ainsi bornée par les tensions d'alimentation inférieure et supérieure.

Ainsi, lorsque le circuit de pilotage pilote la grille du transistor de puissance inférieur afin de fermer ce dernier et les grilles des transistors de puissance supérieurs afin d'ouvrir ces derniers, la tension de sortie du circuit de puissance est égale à la tension d'alimentation inférieure, et lorsque le circuit de pilotage pilote la grille du transistor de puissance inférieur afin d'ouvrir ce dernier et les grilles des transistors de puissance supérieurs afin de fermer l'un des transistors de puissance supérieurs et d'ouvrir les autres transistors de puissance supérieurs, la tension de sortie du circuit de puissance est égale à la tension d'alimentation supérieure ou intermédiaire associée au transistor de puissance supérieur à l'état fermé.

Selon une caractéristique particulière de l'invention, le bloc convertisseur continu-continu à multiples tensions d'alimentation comprend en outre des condensateurs de découplage d'alimentation respectivement disposés en parallèle des N tensions d'alimentation.

Ainsi, les condensateurs de découplage d'alimentation permettent d'assurer la stabilité des transistors HEMT hautes fréquences et de filtrer des parasites présents dans les tensions d'alimentation.

Selon l'invention, le circuit de pilotage comprend, pour chaque grille de transistor HEMT à déplétion du circuit de puissance à piloter, un premier transistor de pilotage HEMT à déplétion, un second transistor de pilotage HEMT à déplétion, des première, seconde et troisième résistances, une diode Schottky et une tension d'alimentation auxiliaire, la source du premier transistor de pilotage étant connectée à la masse, le drain du premier transistor de pilotage étant connecté à l'une des bornes de la première résistance et à l'une des bornes de la seconde résistance, la grille du premier transistor de pilotage étant connectée à une entrée correspondante du circuit de pilotage, la grille du second transistor de pilotage étant connectée à l'autre des bornes de la première résistance, la source du second transistor de pilotage étant connectée à l'autre des bornes de la seconde résistance, à la cathode de la diode Schottky et à l'une des bornes de la troisième résistance, l'anode de la diode Schottky étant connectée à la tension d'alimentation auxiliaire, l'autre des bornes de la troisième résistance étant connectée à la grille du transistor HEMT à déplétion correspondant du circuit de puissance à piloter, le drain du second transistor de pilotage étant connecté à la tension d'alimentation inférieure si celle-ci est connectée à la borne de sortie de conduction du transistor HEMT à déplétion correspondant du circuit de puissance à piloter ou étant connecté à la tension d'alimentation intermédiaire ou supérieure correspondante si celle-ci est connectée à la borne d'entrée de conduction du transistor HEMT à déplétion correspondant du circuit de puissance à piloter, la tension d'alimentation auxiliaire étant supérieure à la tension de pincement du second transistor de pilotage, et la tension d'alimentation inférieure étant supérieure à la tension d'alimentation auxiliaire plus la tension de pincement du transistor HEMT à déplétion correspondant du circuit de puissance à piloter.

Chaque diode Schottky du circuit de pilotage peut être en technologie Si, SiC, GaAs ou GaN mais peut être également basée sur des matériaux semi-conducteurs à base de matériaux du groupe III-V tels que AlGaN, AlN, InAlN, InAlGaN, etc.

L'architecture du circuit de pilotage de grille des transistors de puissance rend le bloc convertisseur continu-continu à multiples tensions d'alimentation extrêmement flexible en fréquence. En effet, le circuit de pilotage de grille des transistors de puissance étant couplé en courant continu, il n'existe aucune limitation en termes de fréquences minimale et maximale de commutation, la fréquence maximale de commutation étant en réalité limitée par la seconde résistance du circuit de pilotage, par la capacité grille-source (C_{GS}) du second transistor de pilotage du circuit de pilotage et par les performances des transistors HEMT à déplétion eux-mêmes.

L'architecture spécifique du circuit de pilotage de grille, permet ainsi d'atteindre des vitesses de commutation très importantes.

De plus, pour chaque transistor HEMT à déplétion du circuit de puissance à piloter, la partie du circuit de pilotage associée au transistor de puissance à piloter correspondant présente une consommation nulle lorsqu'elle rend le transistor de puissance correspondant passant et consomme très peu de puissance lorsque le transistor de puissance correspondant est bloqué, grâce à l'utilisation d'une alimentation auxiliaire et de la diode disposée en sortie de cette alimentation auxiliaire.

La tension d'alimentation auxiliaire doit être supérieure à la tension de pincement du second transistor de pilotage afin que celui-ci puisse se bloquer, et la tension d'alimentation inférieure doit être supérieure à la tension d'alimentation auxiliaire plus la tension de pincement du transistor HEMT à déplétion du circuit de puissance à piloter correspondant afin que le transistor HEMT à déplétion correspondant du circuit de puissance puisse se bloquer.

Les première et troisième résistances sont des résistances de stabilisation permettant de contrôler le risque d'oscillation des transistors HEMT à déplétion présentant des gains très importants.

La seconde résistance influe directement sur la vitesse de commutation du circuit de pilotage de grille, une valeur de seconde résistance plus faible conduisant, pour un développement de grille de second transistor de pilotage donné, à une vitesse de commutation accrue mais impliquant alors une consommation électrique plus importante lorsque le transistor de puissance à piloter est bloqué, un compromis entre vitesse et consommation du circuit de pilotage existant donc pour un développement de grille de second transistor de pilotage donné.

Il est à noter que le circuit de pilotage comprend N parties de pilotage de grille de transistor de puissance pilotant respectivement les grilles des N transistors de puissance.

Selon une caractéristique particulière de l'invention, chaque tension d'entrée au niveau d'une entrée correspondante du circuit de pilotage est négative et comprise entre 0 V et -Vp, Vp étant la tension de pincement du transistor de pilotage dont la grille est connectée à ladite entrée correspondante du circuit de pilotage, ladite tension d'entrée étant délivrée par un circuit d'interface relié à un circuit numérique de commande.

Le circuit numérique de commande est l'un parmi un processeur de signal numérique (DSP), une matrice prédiffusée programmable par l'utilisateur (FPGA), un circuit intégré spécifique (ASIC) ou tout autre circuit numérique permettant de piloter le bloc convertisseur continu-continu.

Le circuit d'interface permet de fournir chaque tension d'entrée au circuit de pilotage à partir de la commande numérique fournie par le circuit numérique de commande.

Selon une caractéristique particulière de l'invention, une seule tension d'entrée à la fois parmi les tensions d'entrée du circuit de pilotage est à l'état activé.

Ainsi, à chaque instant, un unique transistor de puissance HEMT est commandé à l'état passant pour imposer sa tension d'alimentation en tant que tension de sortie du circuit de puissance, les autres transistors de puissance HEMT étant commandés à l'état bloqué.

Il est à noter que le circuit numérique de commande peut également être configuré pour compenser les différences de temps de montée et de descente entre les transistors de puissance à piloter.

Selon une caractéristique particulière de l'invention, les tailles de grille des transistors HEMT à déplétion du circuit de pilotage sont inférieures à celles des transistors HEMT à déplétion du circuit de puissance.

Ceci a pour avantage de rendre significativement minimale la capacité parasite (C_{GS}) du second transistor de pilotage et donc de permettre d'utiliser des valeurs de seconde résistance suffisamment grandes pour que le circuit de pilotage consomme peu de puissance.

Selon une première variante de l'invention, tous les composants du bloc convertisseur continu-continu à multiples tensions d'alimentation sont des composants discrets montés sur une carte à circuits imprimés ou liés à celle-ci par des fils de liaison.

Ainsi, le bloc convertisseur continu-continu à multiples tensions d'alimentation peut être réalisé à partir de composants discrets tels que des transistors, des diodes, des résistances et des condensateurs en boîtier.

Il peut également être réalisé à partir de composants en puce dans un circuit hybride.

Selon une seconde variante de l'invention, tous les composants du bloc convertisseur continu-continu à multiples tensions d'alimentation sont intégrés de manière monolithique dans un circuit intégré.

Ainsi, ceci permet l'intégration du bloc convertisseur continu-continu à multiples tensions d'alimentation et d'un amplificateur RF de puissance alimenté par le bloc convertisseur continu-continu à multiples tensions d'alimentation dans une même technologie et donc intégrés sur une même puce, cette intégration pouvant directement être réalisée de manière monolithique dans un circuit de type MMIC afin d'augmenter l'intégration du bloc convertisseur continu-continu à multiples tensions d'alimentation.

Le circuit électronique peut également comprendre, si besoin, un amplificateur linéaire qui sera alors associé au bloc convertisseur continu-continu à multiples tensions d'alimentations.

Dans le cas d'une réalisation de type MMIC, l'amplificateur linéaire peut être intégré sur le MMIC.

Selon une caractéristique particulière de l'invention, les transistors HEMT du circuit de puissance et les transistors HEMT du circuit de pilotage sont en l'un quelconque parmi le nitrure de gallium (GaN), l'arséniure de gallium (GaAs) ou en tout autre matériau semi-conducteur à base de matériaux de type III-V.

Selon une caractéristique particulière de l'invention, les diodes sont de type Schottky en technologie Si, SiC, GaAs, GaN ou en tout autre matériau semi-conducteur à base de matériaux de type III-V.

De plus, dans le cas d'une intégration monolithique de l'amplificateur RF de puissance et du bloc convertisseur continu-continu à multiples tensions d'alimentation, la technologie des transistors étant identique, les contraintes de tenue en tension sont directement compatibles.

La présente invention a également pour objet un convertisseur continu-continu à multiples tensions d'alimentation forte puissance et hautes fréquences pour la technique de suivi d'enveloppe, caractérisé par le fait qu'il comprend un bloc convertisseur continu-continu à multiples tensions d'alimentation tel que défini ci-dessus et un filtre de sortie connecté à la sortie du circuit de puissance du bloc convertisseur continu-continu à multiples tensions d'alimentation, le filtre étant de préférence à base de condensateurs et d'inductances, la sortie du filtre de sortie constituant la sortie du convertisseur continu-continu à multiples tensions d'alimentation forte puissance et hautes fréquences.

Ainsi, dans le cas d'une application de suivi d'enveloppe à commande continue dans laquelle le convertisseur continu-continu à multiples tensions d'alimentation est utilisé en fonctionnement abaisseur de tension (de type « Buck »), le filtre de sortie, constitué par exemple de condensateurs et d'inductances, permet de reconstruire le signal de polarisation à appliquer sur l'entrée de tension d'alimentation d'un amplificateur RF de puissance à partir d'un signal de commande numérique de type PWM (modulation d'impulsions en largeur) ou sigmadelta. Dans ce cas, l'architecture du bloc convertisseur continu-continu avec un circuit de puissance de type abaisseur de tension est particulièrement optimisée pour la technique de suivi d'enveloppe à travers l'utilisation de N tensions d'alimentation parmi lesquelles les tensions d'alimentation supérieure et inférieure bornent la tension générée par le bloc convertisseur continu-continu, ce qui permet de rendre significativement minimales les pertes lors des phases de commutation du bloc convertisseur continu-continu, les tensions d'alimentation supérieure et intermédiaires devant être supérieures à la tension d'alimentation inférieure afin de veiller au bon fonctionnement du bloc convertisseur continu-continu.

De plus, l'utilisation d'un circuit de puissance de type abaisseur de tension présente également l'avantage d'une simplicité de pilotage dans le cas d'une utilisation pour la technique de suivi d'enveloppe à commande continue. En effet, le circuit de puissance de type abaisseur de tension est plus simple à commander qu'un circuit de puissance de type amplificateur de tension car aisément utilisable sans chaîne de contre-réaction même dans le cas où il est confronté à des variations d'impédance de charge ou pire à l'absence de charge.

Dans le cas d'une application de suivi d'enveloppe à commande discrète dans laquelle le convertisseur continu-continu à multiples tensions d'alimentation est utilisé en fonctionnement sélecteur de tension, le filtre de sortie, constitué par exemple de condensateurs et d'inductances, est un filtre passe-bas ayant simplement pour fonction de maîtriser les temps de commutation entre chaque niveau de tension à appliquer à l'amplificateur RF.

La présente invention a également pour objet un convertisseur continu-continu à multiples tensions d'alimentation forte puissance et hautes fréquences pour la technique de suivi d'enveloppe, caractérisé par le fait qu'il comprend un bloc convertisseur continu-continu à multiples tensions d'alimentation tel que défini ci-dessus, la sortie du circuit de puissance du bloc convertisseur continu-continu à multiples tensions d'alimentation constituant la sortie du convertisseur continu-continu à multiples tensions d'alimentation forte puissance et hautes fréquences.

Ainsi, dans le cas d'une application de suivi d'enveloppe à commande discrète dans laquelle le convertisseur continu-continu à multiples tensions d'alimentation est utilisé en fonctionnement sélecteur de tension, la sortie du circuit de puissance du bloc convertisseur continu-continu à multiples tensions d'alimentation est directement appliquée à l'amplificateur RF, la tension appliquée à l'amplificateur RF étant l'une parmi les N tensions d'alimentation.

La présente invention a également pour objet un système pour la technique de suivi d'enveloppe comprenant un convertisseur continu-continu à multiples tensions d'alimentation pour la technique de suivi d'enveloppe tel que défini ci-dessus, un amplificateur radiofréquence (RF) de puissance et un circuit numérique de traitement de suivi d'enveloppe, le circuit numérique de traitement de suivi d'enveloppe commandant le convertisseur continu-continu à multiples tensions d'alimentation et l'amplificateur RF de puissance, et la sortie du convertisseur continu-continu à multiples tensions d'alimentation étant reliée à l'entrée de tension d'alimentation de l'amplificateur RF de puissance.

La tension d'alimentation supérieure du convertisseur continu-continu à multiples tensions d'alimentation correspond à la tension d'alimentation maximale de l'amplificateur RF de puissance lorsque celui-ci fournit une puissance de sortie maximale, et la tension d'alimentation inférieure du convertisseur continu-continu à multiples tensions d'alimentation correspond à la tension d'alimentation minimale de l'amplificateur RF de puissance lorsque sa puissance de sortie est faible. Les deux tensions d'alimentation supérieure et inférieure sont donc choisies en fonction des caractéristiques électriques hyperfréquences de l'amplificateur RF de puissance à commander suivant la technique de suivi d'enveloppe, les tensions d'alimentation intermédiaires étant choisies selon la statistique des signaux à émettre, cette statistique dépendant elle-même du format de modulation et des caractéristiques électriques hyperfréquences de l'amplificateur RF de puissance à alimenter.

Pour mieux illustrer l'objet de la présente invention, on va en décrire ci-après, à titre illustratif et non limitatif, un mode de réalisation préféré, avec référence au dessin annexé.

Sur ce dessin :

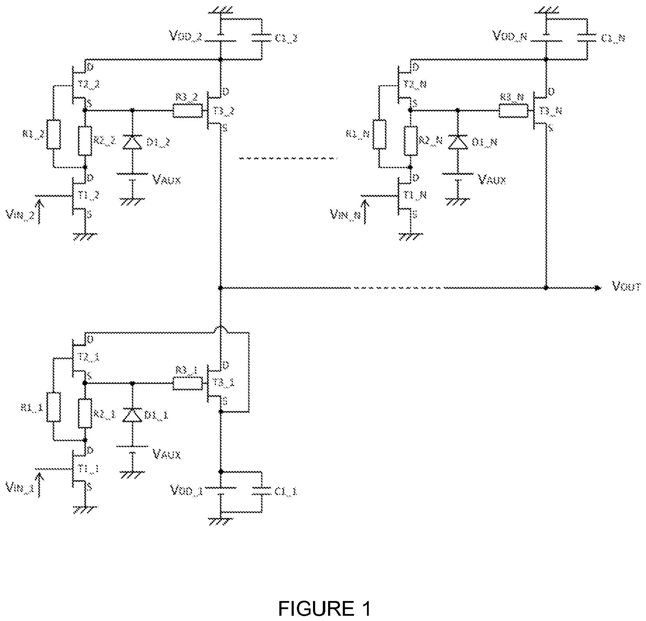

- la Figure 1 est un schéma de principe d'un bloc convertisseur continu-continu à multiples tensions d'alimentation selon la présente invention.

Si l'on se réfère à la Figure 1, on peut voir qu'il y est représenté un bloc convertisseur continu-continu à multiples tensions d'alimentation selon la présente invention.

Le bloc convertisseur continu-continu à multiples tensions d'alimentation comprend un circuit de puissance alimenté par N tensions d'alimentation positives et non nulles, à savoir une tension d'alimentation inférieure VDD_1, une tension d'alimentation supérieure VDD_N et (N-2) tensions d'alimentation intermédiaires VDD_2 à VDD_N-1, N étant un nombre entier naturel supérieur ou égal à 3, la tension d'alimentation supérieure VDD_N étant supérieure à la tension d'alimentation inférieure VDD_1, les (N-2) tensions d'alimentation intermédiaires VDD_2 à VDD_N-1 étant réparties, de manière uniforme ou non uniforme, entre les tensions d'alimentation inférieure VDD_1 et supérieure VDD_N.

Il est à noter que seuls les composants associés aux tensions d'alimentation VDD_1, VDD_2 et VDD_N ont été représentés à la Figure 1 afin de faciliter la compréhension du lecteur.

Le bloc convertisseur continu-continu à multiples tensions d'alimentation comprend en outre un circuit de pilotage du circuit de puissance.

Les tensions d'alimentation inférieure VDD_1 et supérieure VDD_N sont choisies en fonction des caractéristiques électriques hyperfréquences d'un amplificateur RF de puissance alimenté par un convertisseur continu-continu comprenant le bloc convertisseur continu-continu à multiples tensions d'alimentation, et peuvent avoir, par exemple, respectivement des valeurs de 20 V et 50 V.

Le circuit de puissance comprend un transistor de puissance inférieur HEMT à déplétion T3_1 et (N-1) transistors de puissance supérieurs HEMT à déplétion T3_2 à T3_N, la source du transistor de puissance inférieur T3_1 étant connectée à la tension d'alimentation inférieure VDD_1, le drain de l'un T3_N des transistors de puissance supérieurs T3_2 à T3_N étant connecté à la tension d'alimentation supérieure VDD_N, les drains des (N-2) autres transistors de puissance supérieurs T3_2 à T3_N-1 étant respectivement connectés aux (N-2) tensions d'alimentation intermédiaires VDD_2 à VDD_N-1, la sortie V_{OUT} du circuit de puissance étant connectée au drain du transistor de puissance inférieur T3_1 et aux sources des (N-1) transistors de puissance supérieurs T3_2 à T3_N, et les grilles des transistors de puissance inférieur T3_1 et supérieurs T3_2 à T3_N étant connectées au circuit de pilotage du bloc convertisseur continu-continu à multiples tensions d'alimentation, de telle sorte que la tension de sortie V_{OUT} du circuit de puissance du bloc convertisseur continu-continu à multiples tensions d'alimentation est bornée par les tensions d'alimentation inférieure VDD_1 et supérieure VDD_N.

Le bloc convertisseur continu-continu à multiples tensions d'alimentation comprend en outre des condensateurs de découplage d'alimentation C1_1 à C1_N respectivement disposés en parallèle des N tensions d'alimentation VDD_1 à VDD_N.

Les condensateurs C1_1 à C1_N ont, par exemple, des valeurs comprises entre 10pF et 1nF, l'homme du métier sachant ajuster les valeurs en fonction des autres composants et des caractéristiques requises.

Il est à noter que le bloc convertisseur continu-continu à multiples tensions d'alimentation pourrait ne pas comprendre de condensateurs de découplage d'alimentation, sans s'écarter du cadre de la présente invention.

Le circuit de pilotage est configuré pour piloter les grilles des transistors de puissance T3_1 à T3_N, et comprend, pour chaque grille de transistor HEMT à déplétion T3_1 à T3_N du circuit de puissance à piloter, un premier transistor de pilotage HEMT à déplétion T1_1 à T1_N, un second transistor de pilotage HEMT à déplétion T2_1 à T2_N, des première, seconde et troisième résistances R1_1 à R1_N, R2_1 à R2_N et R3_1 à R3_N, une diode Schottky D1_1 à D1_N et une tension d'alimentation auxiliaire V_{AUX}, la source du premier transistor de pilotage T1_1 à T1_N étant connectée à la masse, le drain du premier transistor de pilotage T1_1 à T1_N étant connecté à l'une des bornes de la première résistance R1_1 à R1_N et à l'une des bornes de la seconde résistance R2_1 à R2_N, la grille du premier transistor de pilotage T1_1 à T1_N étant connectée à une entrée V_{IN_1} à V_{IN}-_{N} correspondante du circuit de pilotage, la grille du second transistor de pilotage T2_1 à T2_N étant connectée à l'autre des bornes de la première résistance R1_1 à R1_N, la source du second transistor de pilotage T2_1 à T2_N étant connectée à l'autre des bornes de la seconde résistance R2_1 à R2_N, à la cathode de la diode Schottky D1_1 à D1_N et à l'une des bornes de la troisième résistance R3_1 à R3_N, l'anode de la diode Schottky D1_1 à D1_N étant connectée à la tension d'alimentation auxiliaire V_{AUX}, l'autre des bornes de la troisième résistance R3_1 à R3_N étant connectée à la grille du transistor HEMT à déplétion T3_1 à T3_N correspondant du circuit de puissance à piloter.

Le drain du second transistor de pilotage T2_1 associé au transistor de puissance inférieur T3_1 est connecté à la tension d'alimentation inférieure VDD_1.

Le drain du second transistor de pilotage T2_N associé au transistor de puissance supérieur T3_N est connecté à la tension d'alimentation supérieure VDD_N.

Chaque drain des seconds transistors de pilotage T2_2 à T2_N-1 associés aux transistors de puissance supérieurs T3_2 à T3_N-1 est connecté à la tension d'alimentation intermédiaire VDD_2 à VDD_N-1 correspondante.

La tension d'alimentation auxiliaire V_{AUX} est supérieure à la tension de pincement du second transistor de pilotage T2_1 à T2_N afin que ce dernier puisse s'ouvrir, et la tension d'alimentation inférieure VDD_1 est supérieure à la tension d'alimentation auxiliaire V_{AUX} plus la tension de pincement du transistor de puissance HEMT à déplétion T3_1 à T3_N correspondant afin que ce dernier puisse s'ouvrir.

La tension auxiliaire V_{AUX} est, par exemple, de 3 V.

Il est à noter que la tension auxiliaire Vₐᵤₓ pourrait également être différente pour chaque partie de circuit de pilotage associée à un transistor de puissance T3_1 à T3_N, sans s'écarter du cadre de la présente invention.

Les développements de grille des transistors de pilotage HEMT à déplétion T1_1 à T1_N et T2_1 à T2_N du circuit de pilotage sont beaucoup plus faibles que ceux des transistors de puissance HEMT à déplétion T3_1 à T3_N du circuit de puissance. Les transistors de pilotage T1_1 à T1_N et T2_1 à T2_N ont, par exemple, des développements de grille 10 à 30 fois plus faibles que ceux des transistors de puissance T3_1 à T3_N.

Il est à noter que le dimensionnement des transistors de puissance HEMT T3_1 à T3_N peut être différent pour chaque transistor de puissance HEMT T3_1 à T3_N en fonction des tensions d'alimentation VDD_1 à VDD_N présentées à ceux-ci.

Les première, seconde et troisième résistances R1_1 à R1_N, R2_1 à R2_N et R3_1 à R3_N ont, par exemple, respectivement des valeurs de 10 Ohms, 50 Ohms et 10 Ohms.

Ces valeurs dépendent bien entendu de nombreux facteurs tels que les transistors ou la technologie utilisée. Elles sont donc indiquées ici de manière illustrative et non limitative et l'homme du métier saura les adapter en fonction des caractéristiques du convertisseur.

Il est à noter que les transistors HEMT à déplétion T1_1 à T1_N, T2_1 à T2_N et T3_1 à T3_N présentent l'avantage de pouvoir être utilisés en conduction directe et inverse, et ne nécessitent donc pas obligatoirement l'usage de diodes Schottky antiparallèles pour la gestion des courants inverses, ce qui permet de rendre minimales les capacités parasites dans le montage.

Différentes technologies de semi-conducteurs peuvent être utilisées pour la réalisation des transistors HEMT à déplétion T1_1 à T1_N, T2_1 à T2_N et T3_1 à T3_N, ces matériaux étant principalement le nitrure de gallium (GaN) et l'arséniure de gallium (GaAs) mais aussi tout autre matériau semi-conducteur à base de matériaux du groupe III-V tels que AlGaN, AlN, InAlN, InAlGaN, etc.

Les diodes Schottky D1_1 à D1_N peuvent être en technologie Si, SiC, GaAs ou GaN mais peuvent être également basées sur des matériaux semi-conducteurs à base de matériaux du groupe III-V tels que AlGaN, AlN, InAlN, InAlGaN, etc.

Chaque tension d'entrée V_{IN_1} à V_{IN_N} au niveau d'une entrée correspondante du circuit de pilotage est négative et comprise entre 0 V et -Vp, Vp étant la tension de pincement du transistor de pilotage T1_1 à T1_N dont la grille est connectée à ladite entrée correspondante du circuit de pilotage, lesdites tensions d'entrée V_{IN_1} à V_{IN_N} étant délivrées par un circuit d'interface (non représenté à la Figure 1) relié à un circuit numérique de commande.

Le circuit numérique de commande est l'un parmi un processeur de signal numérique (DSP), une matrice prédiffusée programmable par l'utilisateur (FPGA), un circuit intégré spécifique (ASIC) ou tout autre circuit numérique permettant de piloter le bloc convertisseur continu-continu à multiples tensions d'alimentation.

Le circuit d'interface permet de fournir chaque tension d'entrée au circuit de pilotage à partir des commandes numériques fournies par le circuit numérique de commande.

Chaque partie de circuit de pilotage est associée à un transistor de puissance T3_1 à T3_N de telle sorte qu'un seul transistor de puissance T3_1 à T3_N à la fois est à l'état passant. Deux états sont ainsi possibles pour caractériser une partie de circuit de pilotage associée à un transistor de puissance T3_1 à T3_N.

Dans le cas à titre d'exemple du transistor de puissance T3_1, dans un premier état, désigné par « état d'extinction » dans lequel le signal numérique de commande impose une tension d'entrée V_{IN1_1} = 0 V, le premier transistor de pilotage T1_1 est fermé, la grille du second transistor de pilotage T2_1 est mise à la masse ainsi que la borne de la seconde résistance R2_1 connectée au drain du premier transistor de pilotage T1_1, imposant ainsi un courant dans la seconde résistance R2_1 en provenance de l'alimentation auxiliaire V_{AUX} à travers la diode D1_1. La tension résultante aux bornes de la seconde résistance R2_1 ouvre le second transistor de pilotage T2_1 et la tension auxiliaire V_{AUX} est appliquée à la grille du transistor de puissance à piloter T3_1, bloquant ainsi celui-ci quel que soit lequel des autres transistors de puissance T3_2 à T3_N est à l'état passant. Ainsi, dans cet état, la consommation du circuit de pilotage est réduite au courant traversant la seconde résistance R2_1 et la diode D1_2 en provenance de la tension auxiliaire V_{AUX}.

En raison du fait que les transistors utilisés sont des transistors HEMT hyperfréquences présentant des gains très importants, il existe un risque d'oscillation (d'instabilité) desdits transistors. Afin de contrôler ce risque, les première et troisième résistances R1_1 à R1_N et R3_1 à R3_N qui sont des résistances de stabilisation ont été positionnées sur les grilles du premier transistor de pilotage T1_1 à T1_N et du transistor de puissance à piloter T3_1 à T3_N.

Il est à noter que le bloc convertisseur continu-continu à multiples tensions d'alimentation pourrait ne pas comprendre de résistances de stabilisation R1_1 à R1_N et R3_1 à R3_N, sans s'écarter du cadre de la présente invention.

Toujours dans le cas à titre d'exemple du transistor de puissance T3_1, dans un second état, désigné « état d'activation » dans lequel le signal numérique de commande impose une tension d'entrée V_{IN1} = - Vp, le premier transistor de pilotage T1_1 est ouvert. Le courant dans la seconde résistance R2_1 étant nul, la tension grille-source du seconde transistor de pilotage T2_1 est égale à 0 V et le second transistor de pilotage T2_1 est donc fermé, imposant ainsi la tension d'alimentation inférieure VDD_1 sur la grille du transistor de puissance T3_1 et bloquant la diode D1_1. Le transistor de puissance T3_1 est ainsi fermé, imposant la tension d'alimentation inférieure VDD_1 sur la tension de sortie V_{OUT} du circuit de puissance, les autres transistors de puissance T3_2 à T3_N étant à l'état bloqué. Dans cet état, la diode D1_1 et le premier transistor de pilotage T1_1 étant bloqués, la consommation du circuit de pilotage de grille est nulle.

Le bloc convertisseur continu-continu à multiples tensions d'alimentation permet ainsi, par l'intermédiaire du circuit de pilotage piloté par des signaux numériques, la sélection en tant que tension de sortie V_{OUT} d'une tension d'alimentation unique parmi les N tensions d'alimentation VDD_1 à VDD_N.

Il est à noter que le circuit numérique de commande peut être configuré pour compenser les différences de temps de montée et de descente entre les transistors de puissance T3_1 à T3_N.

La seconde résistance R2_1 à R2_N influe directement sur la vitesse de commutation du circuit de pilotage de grille. Pour un développement de grille de second transistor de pilotage T2_1 à T2_N donné, une valeur de seconde résistance R2_1 à R2_N plus faible conduira à une vitesse de commutation accrue mais impliquera alors une consommation plus importante lorsque le transistor de puissance à piloter T3_1 à T3_N sera ouvert. Il existe donc, pour un développement de grille de second transistor de pilotage T2_1 à T2_N donné, un compromis entre vitesse et consommation du circuit de pilotage.

Cependant, l'architecture du bloc convertisseur continu-continu à multiples tensions d'alimentation présente l'avantage que les premier et second transistors de pilotage T1_1 à T1_N et T2_1 à T2_N de développements de grille très faibles vis-à-vis du développement de grille du transistor de puissance T3_1 à T3_N suffisent à piloter le transistor de puissance T3_1 à T3_N car il n'est pas nécessaire de fournir un fort courant pour piloter la grille du transistor de puissance T3_1 à T3_N. Ceci a pour avantage de minimiser significativement la capacité parasite grille-source du second transistor de pilotage T2_1 à T2_N qui sera ainsi très faible et donc permettra d'utiliser des valeurs de seconde résistance R2_1 à R2_N suffisamment grandes pour que le circuit de pilotage consomme peu.

Tous les composants du bloc convertisseur continu-continu à multiples tensions d'alimentation sont soit des composants discrets montés sur une carte à circuits imprimés, soit intégrés de manière monolithique dans un circuit intégré.

Dans le cas d'une intégration de manière monolithique, cela peut permettre l'intégration d'un convertisseur continu-continu comprenant le bloc convertisseur continu-continu à multiples tensions d'alimentation et d'un amplificateur RF de puissance alimenté par le convertisseur continu-continu dans une même technologie et donc intégrés sur une même puce, cette intégration pouvant directement être réalisée de manière monolithique dans un circuit de type MMIC afin d'augmenter l'intégration du convertisseur continu-continu.

Les transistors de puissance HEMT T3_1 à T3_N pouvant fonctionner en conduction directe ou inverse, c'est-à-dire suivant deux quadrants (V_{DS}, I_{DS}) > 0 ou (V_{DS}, I_{DS}) < 0, il en résulte que chaque transistor de puissance T3_1 à T3_N peut être monté en inversant le drain et la source, le câblage du circuit de pilotage restant dans ces conditions inchangé, chacun des transistors de puissance T3_1 à T3_N pouvant être inversé de manière indépendante les uns des autres.

Il est à noter que les diodes de pilotage D1_1 à D1_N pourraient être remplacées par des transistors de type HEMT de même technologie que les autres transistors du circuit, sans s'écarter du cadre de la présente invention.

L'invention a également pour objet un convertisseur continu-continu à multiples tensions d'alimentation forte puissance et hautes fréquences pour la technique de suivi d'enveloppe, caractérisé par le fait qu'il comprend un bloc convertisseur continu-continu à multiples tensions d'alimentation tel que défini ci-dessus et facultativement un filtre de sortie connecté à la sortie du circuit de puissance du bloc convertisseur continu-continu à multiples tensions d'alimentation, le filtre étant de préférence à base de condensateurs et d'inductances, la sortie du filtre de sortie constituant la sortie du convertisseur continu-continu à multiples tensions d'alimentation forte puissance et hautes fréquences.

Dans le cas d'une application de suivi d'enveloppe à commande continue dans laquelle le convertisseur continu-continu à multiples tensions d'alimentation est utilisé en fonctionnement abaisseur de tension (de type « Buck »), le filtre de sortie, constitué par exemple de condensateurs et d'inductances, permet de reconstruire le signal de polarisation à appliquer sur l'entrée de tension d'alimentation d'un amplificateur RF de puissance à partir d'un signal de commande numérique de type PWM (modulation d'impulsions en largeur) ou sigmadelta. Ainsi, le bloc convertisseur continu-continu à multiples tensions d'alimentation associé au filtre de reconstruction en sortie présente l'avantage de diminuer l'ondulation résiduelle en sortie vis-à-vis d'un convertisseur abaisseur de tension classique, d'augmenter la bande passante du convertisseur et également de diminuer les pertes par commutation.

Dans le cas d'une application de suivi d'enveloppe à commande discrète dans laquelle le convertisseur continu-continu à multiples tensions d'alimentation est utilisé en fonctionnement sélecteur de tension, le filtre de sortie, constitué par exemple de condensateurs et d'inductances, est un filtre passe-bas ayant simplement pour fonction de maîtriser les temps de commutation entre chaque niveau de tension à appliquer à l'amplificateur RF. Ainsi, ce convertisseur continu-continu permet d'atteindre des fréquences de commutation élevées et donc de large bande passante avec un bon rendement.

Il est à noter que dans le cas d'une application de suivi d'enveloppe à commande discrète, la sortie du circuit de puissance du bloc convertisseur continu-continu à multiples tensions d'alimentation peut également être directement appliquée à l'amplificateur RF, la tension appliquée à l'amplificateur RF étant l'une parmi les N tensions d'alimentation.

L'invention a également pour objet un système pour la technique de suivi d'enveloppe comprenant un convertisseur continu-continu à multiples tensions d'alimentation pour la technique de suivi d'enveloppe selon la présente invention, un amplificateur radiofréquence (RF) de puissance et un circuit numérique de traitement de suivi d'enveloppe, le circuit numérique de traitement de suivi d'enveloppe commandant le convertisseur continu-continu à multiples tensions d'alimentation et l'amplificateur RF de puissance, et la sortie du convertisseur continu-continu à multiples tensions d'alimentation étant reliée à l'entrée de tension d'alimentation de l'amplificateur RF de puissance.

Ainsi, la tension d'alimentation supérieure VDD_N du convertisseur continu-continu à multiples tensions d'alimentation correspond à la tension d'alimentation maximale de l'amplificateur RF de puissance lorsque celui-ci fournit une puissance de sortie maximale, et la tension d'alimentation inférieure VDD_1 du convertisseur continu-continu à multiples tensions d'alimentation correspond à la tension d'alimentation minimale de l'amplificateur RF de puissance lorsque sa puissance de sortie est faible.

## Revendications

1. Bloc convertisseur continu-continu à multiples tensions d'alimentation forte puissance et hautes fréquences comprenant un circuit de puissance dont la sortie constitue la sortie du bloc convertisseur continu-continu, le circuit de puissance comprenant N transistors HEMT (à haute mobilité d'électrons) à déplétion (T3_1, T3_2, T3_N), N étant un nombre entier naturel supérieur ou égal à 3, le bloc convertisseur continu-continu comprenant en outre un circuit de pilotage de grille des N transistors HEMT à déplétion (T3_1, T3_2, T3_N) du circuit de puissance, le circuit de pilotage comprenant des transistors HEMT à déplétion (T1_1, T2_1, T1_2, T2_2, T1_N, T2_N) configurés pour piloter les grilles des N transistors HEMT à déplétion (T3_1, T3_2, T3_N) du circuit de puissance, **caractérisé par le fait que** le circuit de puissance est alimenté par N tensions d'alimentation positives et non nulles, à savoir une tension d'alimentation inférieure (VDD_1), une tension d'alimentation supérieure (VDD_N) et (N-2) tension(s) d'alimentation intermédiaire(s) (VDD_2), la tension d'alimentation supérieure (VDD_N) étant supérieure à la tension d'alimentation inférieure (VDD_1), chaque tension d'alimentation intermédiaire (VDD_2) étant différente des tensions d'alimentation inférieure (VDD_1) et supérieure (VDD_N) et les (N-2) tensions d'alimentation intermédiaires (VDD_2) étant différentes deux à deux et comprises entre les tensions d'alimentation inférieure (VDD_1) et supérieure (VDD_N),
le circuit de pilotage comprenant en outre, pour chaque grille de transistor HEMT à déplétion (T3_1; T3_2; T3_N) du circuit de puissance à piloter, un premier transistor de pilotage HEMT à déplétion (T1_1 ; T1_2; T1_N), un second transistor de pilotage HEMT à déplétion (T2_1; T2_2 ; T2_N), des première, seconde et troisième résistances (R1_1, R2_1, R3_1 ; Rl_2, R2_2, R3_2 ; R1_N, R2_N, R3_N), une diode Schottky (Dl_l ; Dl_2 ; D1_N) et une tension d'alimentation auxiliaire (V_{AUX}), la source du premier transistor de pilotage (T1_1 ; T1_2 ; T1_N) étant connectée à la masse, le drain du premier transistor de pilotage (T1_1 ; Tl_2 ; T1_N) étant connecté à l'une des bornes de la première résistance (R1_1 ; Rl_2 ; R1_N) et à l'une des bornes de la seconde résistance (R2_1 ; R2_2 ; R2_N), la grille du premier transistor de pilotage (T1_1 ; T1_2 ; T1_N) étant connectée à une entrée (V_{IN}-₁ ; V_{IN}-₂ ; V_{IN}__{N}) correspondante du circuit de pilotage, la grille du second transistor de pilotage (T2_1 ; T2_2 ; T2_N) étant connectée à l'autre des bornes de la première résistance (R1_1 ; R1_2 ; R1_N), la source du second transistor de pilotage (T2_1 ; T2_2 ; T2_N) étant connectée à l'autre des bornes de la seconde résistance (R2_1 ; R2_2 ; R2_N), à la cathode de la diode Schottky (D1_1 ; D1_2 ; D1_N) et à l'une des bornes de la troisième résistance (R3_1 ; R3_2 ; R3_N), l'anode de la diode Schottky (D1_1 ; D1_2 ; D1_N) étant connectée à la tension d'alimentation auxiliaire (V_{AUX}), l'autre des bornes de la troisième résistance (R3_1 ; R3_2 ; R3_N) étant connectée à la grille du transistor HEMT à déplétion (T3_1 ; T3_2 ; T3_N) correspondant du circuit de puissance à piloter, le drain du second transistor de pilotage (T2_1 ; T2_2 ; T2_N) étant connecté à la tension d'alimentation inférieure (VDD_1) si celle-ci est connectée à la borne de sortie de conduction du transistor HEMT à déplétion (T3_1) correspondant du circuit de puissance à piloter ou étant connecté à la tension d'alimentation intermédiaire ou supérieure (VDD_2 ; VDD_N) correspondante si celle-ci est connectée à la borne d'entrée de conduction du transistor HEMT à déplétion (T3_2 ; T3_N) correspondant du circuit de puissance à piloter, la tension d'alimentation auxiliaire (V_{AUX}) étant supérieure à la tension de pincement du second transistor de pilotage (T2_1; T2_2 ; T2_N), et la tension d'alimentation inférieure (VDD_1) étant supérieure à la tension d'alimentation auxiliaire (V_{AUX}) plus la tension de pincement du transistor HEMT à déplétion (T3_1 ; T3_2 ; T3_N) correspondant du circuit de puissance à piloter.

2. Bloc convertisseur continu-continu à multiples tensions d'alimentation selon la revendication 1, **caractérisé par le fait que** le circuit de puissance comprend un transistor de puissance inférieur HEMT à déplétion (T3_1) et (N-1) transistors de puissance supérieurs HEMT à déplétion (T3_2, T3_N), la borne de sortie de conduction du transistor de puissance inférieur (T3_1) étant connectée à la tension d'alimentation inférieure (VDD_1), la borne d'entrée de conduction de l'un (T3_N) des transistors de puissance supérieurs (T3_2, T3_N) étant connectée à la tension d'alimentation supérieure (VDD_N), les bornes d'entrée de conduction des (N-2) autres transistors de puissance supérieurs (T3_2) étant respectivement connectées aux (N-2) tensions d'alimentation intermédiaires (VDD_2), la sortie (V_{OUT}) du circuit de puissance étant connectée à la borne d'entrée de conduction du transistor de puissance inférieur (T3_1) et aux bornes de sortie de conduction des (N-1) transistors de puissance supérieurs (T3_2, T3_N), et les grilles des transistors de puissance inférieur (T3_1) et supérieurs (T3_2, T3_N) étant connectées au circuit de pilotage du bloc convertisseur continu-continu, de telle sorte que la tension de sortie (V_{OUT}) du circuit de puissance du bloc convertisseur continu-continu est bornée par les tensions d'alimentation inférieure (VDD_1) et supérieure (VDD_N).

3. Bloc convertisseur continu-continu à multiples tensions d'alimentation selon la revendication 1 ou la revendication 2, **caractérisé par le fait qu'**il comprend en outre des condensateurs de découplage d'alimentation (C1_1, C1_2, C1_N) respectivement disposés en parallèle des N tensions d'alimentation (VDD_1, VDD_2, VDD_N).

4. Bloc convertisseur continu-continu à multiples tensions d'alimentation selon l'une des revendications 1 à 3, **caractérisé par le fait que** chaque tension d'entrée (V_{IN_1} ; V_{IN_2} ; V_{IN}__{N}) au niveau d'une entrée correspondante du circuit de pilotage est négative et comprise entre 0 V et -Vp, Vp étant la tension de pincement du transistor de pilotage (T1_1 ; T1_2 ; T1_N) dont la grille est connectée à ladite entrée correspondante du circuit de pilotage, ladite tension d'entrée (V_{IN_1} ; V_{IN_2} ; V_{IN}__{N}) étant délivrée par un circuit d'interface relié à un circuit numérique de commande.

5. Bloc convertisseur continu-continu à multiples tensions d'alimentation selon l'une des revendications 1 à 4, **caractérisé par le fait qu'**une seule tension d'entrée à la fois parmi les tensions d'entrée (V_{IN_1} ; V_{IN_2} ; V_{IN_N}) du circuit de pilotage est à l'état activé.

6. Bloc convertisseur continu-continu à multiples tensions d'alimentation selon l'une des revendications 1 à 5, **caractérisé par le fait que** les tailles de grille des transistors HEMT à déplétion (T1_1, T1_2, T1_N, T2_1, T2_2, T2_N) du circuit de pilotage sont inférieures à celles des transistors HEMT à déplétion (T3_1, T3_2, T3_N) du circuit de puissance.

7. Bloc convertisseur continu-continu à multiples tensions d'alimentation selon l'une des revendications 1 à 6, **caractérisé par le fait que** tous les composants du bloc convertisseur continu-continu à multiples tensions d'alimentation sont des composants discrets montés sur une carte à circuits imprimés ou liés à celle-ci par des fils de liaison.

8. Bloc convertisseur continu-continu à multiples tensions d'alimentation selon l'une des revendications 1 à 6, **caractérisé par le fait que** tous les composants du bloc convertisseur continu-continu à multiples tensions d'alimentation sont intégrés de manière monolithique dans un circuit intégré.

9. Bloc convertisseur continu-continu à multiples tensions d'alimentation selon l'une des revendications 1 à 8, **caractérisé par le fait que** les transistors HEMT (T3_1, T3_2, T3_N) du circuit de puissance et les transistors HEMT (T1_1, T1_2, T1_N, T2_1, T2_2, T2_N) du circuit de pilotage sont en l'un quelconque parmi le nitrure de gallium (GaN), l'arséniure de gallium (GaAs) ou en tout autre matériau semi-conducteur à base de matériaux de type III-V.

10. Bloc convertisseur continu-continu à multiples tensions d'alimentation selon l'une des revendications 1 à 9, **caractérisé par le fait que** les diodes (D1_1, D1_2, D1_N) sont de type Schottky en technologie Si, SiC, GaAs, GaN ou en tout autre matériau semi-conducteur à base de matériaux de type III-V.

11. Convertisseur continu-continu à multiples tensions d'alimentation forte puissance et hautes fréquences pour la technique de suivi d'enveloppe, **caractérisé par le fait qu'**il comprend un bloc convertisseur continu-continu à multiples tensions d'alimentation selon l'une des revendications 1 à 10 et un filtre de sortie connecté à la sortie du circuit de puissance du bloc convertisseur continu-continu à multiples tensions d'alimentation, le filtre étant de préférence à base de condensateurs et d'inductances, la sortie du filtre de sortie constituant la sortie du convertisseur continu-continu à multiples tensions d'alimentation forte puissance et hautes fréquences.

12. Convertisseur continu-continu à multiples tensions d'alimentation forte puissance et hautes fréquences pour la technique de suivi d'enveloppe, **caractérisé par le fait qu'**il comprend un bloc convertisseur continu-continu à multiples tensions d'alimentation selon l'une des revendications 1 à 10, la sortie du circuit de puissance du bloc convertisseur continu-continu à multiples tensions d'alimentation constituant la sortie du convertisseur continu-continu à multiples tensions d'alimentation forte puissance et hautes fréquences.

13. Système pour la technique de suivi d'enveloppe comprenant un convertisseur continu-continu à multiples tensions d'alimentation pour la technique de suivi d'enveloppe selon la revendication 11 ou la revendication 12, un amplificateur radiofréquence (RF) de puissance et un circuit numérique de traitement de suivi d'enveloppe, le circuit numérique de traitement de suivi d'enveloppe commandant le convertisseur continu-continu à multiples tensions d'alimentation et l'amplificateur RF de puissance, et la sortie du convertisseur continu-continu à multiples tensions d'alimentation étant reliée à l'entrée de tension d'alimentation de l'amplificateur RF de puissance.

## Patentansprüche

1. Gleichspannungswandlerblock mit mehreren Hochleistungs- und Hochfrequenz-Versorgungsspannungen, umfassend eine Leistungsschaltung, deren Ausgang den Ausgang des Gleichspannungswandlerblocks bildet, wobei die Leistungsschaltung N HEMT-Transistoren (mit hoher Elektronenbeweglichkeit) vom Verarmungstyp (T3_1, T3_2, T3_N) umfasst, wobei N eine natürliche Ganzzahl größer oder gleich 3 ist, wobei der Gleichspannungswandlerblock ferner eine Gittersteuerschaltung der N HEMT-Transistoren vom Verarmungstyp (T3_1, T3_2, T3_N) der Leistungsschaltung umfasst, wobei die Treiberschaltung HEMT-Transistoren vom Verarmungstyp (T1_1, T2_1, T1_2, T2_2, T1_N, T2_N) umfasst, die konfiguriert sind, um die Gitter der N HEMT-Transistoren vom Verarmungstyp (T3_1, T3_2, T3_N) der Leistungsschaltung zu steuern, **dadurch gekennzeichnet, dass** die Leistungsschaltung von N Versorgungsspannungen, die positiv und nicht Null sind, versorgt wird, nämlich einer unteren Versorgungsspannung (VDD_1), einer oberen Versorgungsspannung (VDD_N) und (N-2) Übergangs-Versorgungsspannung(en) (VDD_2), wobei die obere Versorgungsspannung (VDD_N) höher als die untere Versorgungsspannung (VDD_1) ist, wobei sich jede Übergangs-Versorgungsspannung (VDD_2) von der unteren (VDD_1) und oberen (VDD_N) Versorgungsspannung unterscheidet und die (N-2) Übergangs-Versorgungsspannungen (VDD_2) paarig unterschiedlich sind und zwischen der unteren (VDD_1) und oberen (VDD_N) Versorgungsspannungen liegen,
wobei die Treiberschaltung ferner für jedes Gitter eines HEMT-Transistors vom Verarmungstyp (T3_1; T3_2; T3_N) der zu steuernden Leistungsschaltung einen ersten HEMT-Treibertransistor vom Verarmungstyp (T1_1; T1_2; T1_N), einen zweiten HEMT-Treibertransistor vom Verarmungstyp (T2_1; T2_2; T2_N), einen ersten, zweiten und dritten Widerstand (R1_1, R2_1, R3_1; R1_2, R2_2, R3_2; R1_N, R2_N, R3_N), eine Schottky-Diode (D1_1; D1_2; D1_N) und eine Hilfs-Versorgungsspannung (V_{AUX}) umfasst, wobei die Quelle des ersten Treibertransistors (T1_1; T1_2; T1_N) mit der Masse verbunden ist, wobei der Drain des ersten Treibertransistors (T1_1; T1_2; T1_N) mit der einen der Klemmen des ersten Widerstands (R1_1; R1_2; R1_N) und mit der einen der Klemmen des zweiten Widerstands (R2_1; R2_2; R2_N) verbunden ist, wobei das Gitter des ersten Treibertransistors (T1_1; T1_2; T1_N) mit einem entsprechenden Eingang (V_{IN_1}; V_{IN_2}; V_{IN_N}) der Treiberschaltung verbunden ist, wobei das Gitter des zweiten Treibertransistors (T2_1; T2_2; T2_N) mit der anderen der Klemmen des ersten Widerstands (R1_1; R1_2; R1_N) verbunden ist, wobei die Quelle des zweiten Treibertransistors (T2_1; T2_2; T2_N) mit der anderen der Klemmen des zweiten Widerstands (R2_1; R2_2; R2_N), mit der Kathode der Schottky-Diode (D1_1; D1_2; D1_N) und mit der einen der Klemmen des dritten Widerstands (R3_1; R3_2; R3_N) verbunden ist, wobei die Anode der Schottky-Diode (D1_1; D1_2; D1_N) mit der Hilfs-Versorgungsspannung (V_{AUX}) verbunden ist, wobei die andere der Klemmen des dritten Widerstands (R3_1; R3_2; R3_N) mit dem Gitter des entsprechenden HEMT-Transistors vom Verarmungstyp (T3_1; T3_2; T3_N) der zu steuernden Leistungsschaltung verbunden ist, wobei der Drain des zweiten Treibertransistors (T2_1; T2_2; T2_N) mit der unteren Versorgungsspannung (VDD_1) verbunden ist, wenn diese mit der Leitungsausgangsklemme des entsprechenden HEMT-Transistors vom Verarmungstyp (T3_1) der zu steuernden Leistungsschaltung verbunden ist oder mit der entsprechenden Übergangs- oder oberen Versorgungsspannung (VDD_2; VDD_N) verbunden ist, wenn diese mit der Leitungseingangsklemme des entsprechenden HEMT-Transistors vom Verarmungstyp (T3_2; T3_N) der zu steuernden Leistungsschaltung verbunden ist, wobei die Hilfs-Versorgungsspannung (V_{AUX}) höher als die Pinch-off-Spannung des zweiten Treibertransistors (T2_1; T2_2; T2_N) ist und die untere Versorgungsspannung (VDD_1) höher als die Hilfs-Versorgungsspannung (V_{AUX}) plus der Pinch-off-Spannung des entsprechenden HEMT-Transistors vom Verarmungstyp (T3_1; T3_2; T3_N) der zu steuernden Leistungsschaltung ist.

2. Gleichspannungswandlerblock mit mehreren Versorgungsspannungen nach Anspruch 1, **dadurch gekennzeichnet, dass** die Leistungsschaltung einen unteren HEMT-Leistungstransistor vom Verarmungstyp (T3_1) und (N-1) obere HEMT-Leistungstransistoren vom Verarmungstyp (T3_2, T3_N) umfasst, wobei die Leitungsausgangsklemme des unteren Leistungstransistors (T3_1) mit der unteren Versorgungsspannung (VDD_1) verbunden ist, wobei die Leitungseingangsklemme von dem einen (T3_N) der oberen Leistungstransistoren (T3_2, T3_N) mit der oberen Versorgungsspannung (VDD_N) verbunden ist, wobei die Leitungseingangsklemmen der (N-2) anderen oberen Leistungstransistoren (T3_2) jeweils mit den (N-2) Übergangs-Versorgungsspannungen (VDD_2) verbunden sind, wobei der Ausgang (V_{OUT}) der Leistungsschaltung mit der Leitungseingangsklemme des unteren Leistungstransistors (T3_1) und mit den Leitungsausgangsklemmen der (N-1) oberen Leistungstransistoren (T3_2, T3_N) verbunden ist, und die Gitter des unteren Leistungstransistors (T3_1) und der oberen Leistungstransistoren (T3_2, T3_N) mit der Treiberschaltung des Gleichspannungswandlerblocks verbunden sind, so dass die Ausgangsspannung (V_{OUT}) der Leistungsschaltung des Gleichspannungswandlerblocks von der unteren (VDD_1) und oberen (VDD_N) Versorgungsspannung begrenzt ist.

3. Gleichspannungswandlerblock mit mehreren Versorgungsspannungen nach Anspruch 1 oder Anspruch 2, **dadurch gekennzeichnet, dass** er ferner Kondensatoren zur Entkoppelung der Versorgung (C1_1, C1_2, C1_N) umfasst, die jeweils parallel zu den N Versorgungsspannungen (VDD_1, VDD_2, VDD_N) angeordnet sind.

4. Gleichspannungswandlerblock mit mehreren Versorgungsspannungen nach einem der Ansprüche 1 bis 3, **dadurch gekennzeichnet, dass** jede Eingangsspannung (V_{IN_1}; V_{IN_2}; V_{IN_N}) im Bereich eines entsprechenden Eingangs der Treiberschaltung negativ ist und zwischen 0 V und -Vp liegt, wobei Vp die Pinch-off-Spannung des Treibertransistors (T1_1; T1_2; T1_N) ist, dessen Gitter mit dem entsprechenden Eingang der Treiberschaltung verbunden ist, wobei die Eingangsspannung (V_{IN_1}; V_{IN_2}; V_{IN_N}) von einer Schnittstellenschaltung bereitgestellt wird, die mit einer digitalen Steuerschaltung verbunden ist.

5. Gleichspannungswandlerblock mit mehreren Versorgungsspannungen nach einem der Ansprüche 1 bis 4, **dadurch gekennzeichnet, dass** eine einzige Eingangsspannung von den Eingangsspannungen (V_{IN_1}; V_{IN_2}; V_{IN}__{N}) der Treiberschaltung auf einmal in aktiviertem Zustand ist.

6. Gleichspannungswandlerblock mit mehreren Versorgungsspannungen nach einem der Ansprüche 1 bis 5, **dadurch gekennzeichnet, dass** die Gittergrößen der HEMT-Transistoren vom Verarmungstyp (T1_1, T1_2, T1_N, T2_1, T2_2, T2_N) der Treiberschaltung kleiner als die der HEMT-Transistoren vom Verarmungstyp (T3_1, T3_2, T3_N) der Leistungsschaltung sind.

7. Gleichspannungswandlerblock mit mehreren Versorgungsspannungen nach einem der Ansprüche 1 bis 6, **dadurch gekennzeichnet, dass** alle Komponenten des Gleichspannungswandlerblocks mit mehreren Versorgungsspannungen diskrete Komponenten sind, die auf einer gedruckten Leiterplatte angebracht oder mit dieser durch Verbindungsdrähte verbunden sind.

8. Gleichspannungswandlerblock mit mehreren Versorgungsspannungen nach einem der Ansprüche 1 bis 6, **dadurch gekennzeichnet, dass** alle Komponenten des Gleichspannungswandlerblocks mit mehreren Versorgungsspannungen monolithisch in einen integrierten Schaltkreis integriert sind.

9. Gleichspannungswandlerblock mit mehreren Versorgungsspannungen nach einem der Ansprüche 1 bis 8, **dadurch gekennzeichnet, dass** die HEMT-Transistoren (T3_1, T3_2, T3_N) der Leistungsschaltung und die HEMT-Transistoren (T1_1, T1_2, T1_N, T2_1, T2_2, T2_N) der Treiberschaltung aus einem von dem Galliumnitrid (GaN), dem Galliumarsenid (GaAs) oder aus jedem anderen Halbleitermaterial auf der Basis von Materialien vom Typ III-V sind.

10. Gleichspannungswandlerblock mit mehreren Versorgungsspannungen nach einem der Ansprüche 1 bis 9, **dadurch gekennzeichnet, dass** die Dioden (D1_1, D1_2, D1_N) vom Typ Schottky in Si-, SiC-, GaAs-, GaN-Technologie oder aus jedem andern Halbleitermaterial auf der Basis von Materialien des Typs III-V sind.

11. Gleichspannungswandler mit mehreren Hochleistungs- und Hochfrequenz-Versorgungsspannungen für die Hüllkurvennachführungstechnik, **dadurch gekennzeichnet, dass** er einen Gleichspannungswandlerblock mit mehreren Versorgungsspannungen nach einem der Ansprüche 1 bis 10 und einen Ausgangsfilter umfasst, der mit dem Ausgang der Leistungsschaltung des Gleichspannungswandlerblocks mit mehreren Versorgungsspannungen verbunden ist, wobei der Filter vorzugsweise auf der Basis von Kondensatoren und Induktanzen ist, wobei der Ausgang des Ausgangsfilters den Ausgang des Gleichspannungswandlers mit mehreren Hochleistungs- und Hochfrequenz-Versorgungsspannungen bildet.

12. Gleichspannungswandler mit mehreren Hochleistungs- und Hochfrequenz-Versorgungsspannungen für die Hüllkurvennachführungstechnik, **dadurch gekennzeichnet, dass** er einen Gleichspannungswandlerblock mit mehreren Versorgungsspannungen nach einem der Ansprüche 1 bis 10 umfasst, wobei der Ausgang der Leistungsschaltung des Gleichspannungswandlerblocks mit mehreren Versorgungsspannungen den Ausgang des Gleichspannungswandlers mit mehreren Hochleistungs- und Hochfrequenz-Versorgungsspannungen bildet.

13. System für die Hüllkurvennachführungstechnik, umfassend einen Gleichspannungswandler mit mehreren Versorgungsspannungen für die Hüllkurvennachführungstechnik nach Anspruch 11 oder Anspruch 12, einen Hochfrequenz-Leistungsverstärker (HF) und eine digitale Schaltung zur Verarbeitung der Hüllkurvennachführung, wobei die digitale Verarbeitungsschaltung der Hüllkurvennachführung den Gleichspannungswandler mit mehreren Versorgungsspannungen und den HF-Leistungsverstärker steuert, und wobei der Ausgang des Gleichspannungswandlers mit mehreren Versorgungsspannungen mit dem Versorgungsspannungseingang des HF-Leistungsverstärkers verbunden ist.

## Claims

1. A high-frequency and high-power multi-power supply voltage dc/dc converter block comprising a power circuit whose output constitutes the output of the dc/dc converter block, the power circuit comprising N depletion high-electron-mobility (HEMT) transistors (T3_1, T3_2, T3_N), N being a positive integer greater than or equal to 3, the dc/dc converter block further comprising a driving circuit of the gates of the N depletion HEMT transistors (T3_1, T3_2, T3_N) of the power circuit, the driving circuit comprising depletion HEMT transistors (T1_1, T2_1, T1_2, T2_2, T1_N, T2_N) configured to drive the gates of the N depletion HEMT transistors (T3_1, T3_2, T3_N) of the power circuit, **characterized in that** the power circuit is power supplied with N non-zero and positive power supply voltages, namely, a low power supply voltage (VDD_1), a high power supply voltage (VDD_N) and (N-2) intermediary power supply voltage(s) (VDD-2), the high power supply voltage (VDD_N) being greater than the low power supply voltage (VDD_1), each intermediary power supply voltage (VDD_2) being different from the low (VDD_1) and high (VDD_N) power supply voltages and the (N-2) intermediary power supply voltages (VDD_2) being different to each other and comprised between the low (VDD_1) and high (VDD_N) power supply voltages, the driving circuit further comprising, for each gate of depletion HEMT transistor (T3_1; T3_2; T3_N) of the power circuit to be driven, a first depletion HEMT driving transistor (T1_1; T1_2; T1_N), a second depletion HEMT driving transistor (T2_1; T2_2; T2_N), first, second and third resistors (R1_1, R2_1, R3_1; R1_2, R2_2, R3_2; R1_N, R2_N, R3_N), a Schottky diode (D1_1; D1_2; D1_N) and an auxiliary power supply voltage (V_{AUX}), the source of the first driving transistor (T1_1; T1_2; T1_N) being connected to the ground, the drain of the first driving transistor (T1_1; T1_2; T1_N) being connected to one of the terminals of the first resistor (R1_1; R1_2; R1_N) and to one of the terminals of the second resistor (R2_1 ; R2_2 ; R2_N), the gate of the first driving transistor (T1_1; T1_2; T1_N) being connected to a corresponding input (V_{IN_1}; V_{IN_2}; V_{IN_N}) of the driving circuit, the gate of the second driving transistor (T2_1; T2_2; T2_N) being connected to the other of the terminals of the first resistor (R1_1; R1_2; R1_N), the source of the second driving transistor (T2_1; T2_2; T2_N) being connected to the other of the terminals of the second resistor (R2_1; R2_2; R2_N), to the cathode of the Schottky diode (D1_1; D1_2; D1_N) and to one of the terminals of the third resistor (R3_1; R3_2; R3_N), the anode of the Schottky diode (D1_1; D1_2; D1_N) being connected to the auxiliary power supply voltage (V_{AUX}), the other of the terminals of the third resistor (R3_1; R3_2; R3_N) being connected to the gate of the corresponding depletion HEMT transistor (T3_1; T3_2; T3_N) of the power circuit to be driven, the drain of the second driving transistor (T2_1; T2_2; T2_N) being connected to the low power supply voltage (VDD_1) if it is connected to the conduction output terminal of the corresponding depletion HEMT transistor (T3_1) of the power circuit to be driven, or being connected to the corresponding intermediary or high power supply voltage (VDD_2; VDD_N) if it is connected to the conduction input terminal of the corresponding depletion HEMT transistor (T3_2; T3_N) of the power circuit to be driven, the auxiliary power supply voltage (V_{AUX}) being greater than the pinch-off voltage of the second driving transistor (T2_1; T2_2; T2_N), and the low power supply voltage (VDD_1) being greater than the auxiliary power supply voltage (V_{AUX}) plus the pinch-off voltage of the corresponding depletion HEMT transistor (T3_1; T3_2; T3_N) of the power circuit to be driven.

2. The multi-power supply voltage dc/dc converter block according to claim 1, **characterized in that** the power circuit comprises a depletion HEMT lower power transistor (T3_1) and (N-1) depletion HEMT upper power transistors (T3_2, T3_N), the conduction output terminal of the lower power transistor (T3_1) being connected to the low power supply voltage (VDD_1), the conduction input terminal of one (T3_N) of the upper power transistors (T3_2, T3_N) being connected to the high power supply voltage (VDD_N), the conduction input terminals of the (N-2) other upper power transistors (T3_2) being respectively connected to the (N-2) intermediary power supply voltages (VDD_2), the output (V_{OUT}) of the power circuit being connected to the conduction input terminal of the lower power transistor (T3_1) and to the conduction output terminals of the (N-1) upper power transistors (T3_2, T3_N), and the gates of the lower (T3_1) and upper (T3_2, T3_N) power transistors being connected to the driving circuit of the dc/dc converter block, such that the output voltage (V_{OUT}) of the power circuit of the dc/dc converter block is bounded by the low (VDD_1) and high (VDD_N) power supply voltages.

3. The multi-power supply voltage dc/dc converter block according to claim 1 or claim 2, **characterized in that** it further comprises power supply bypass capacitors (C1_1, C1_2, C1_N) respectively arranged in parallel to the N power supply voltages (VDD_1, VDD_2, VDD_N).

4. The multi-power supply voltage dc/dc converter block according to one of claims 1-3, **characterized in that** each input voltage (V_{IN_1}; V_{IN_2}; V_{IN_N}) at a corresponding input of the driving circuit is negative and between 0V and -Vp, Vp being the pinch-off voltage of the driving transistor (T1_1; T1_2; T1_N) whose gate is connected to said corresponding input of the driving circuit, said input voltage (V_{IN_1}; V_{IN_2}; V_{IN_N}) being provided by an interface circuit connected to a control digital circuit.

5. The multi-power supply voltage dc/dc converter block according to one of claims 1 to 4, **characterized in that** only one input voltage at a time, among the input voltages (V_{IN_1}; V_{IN_2}; V_{IN_N}) of the driving circuit, is in an activated state.

6. The multi-power supply voltage dc/dc converter block according to one of claims 1-5, **characterized in that** the sizes of gate of the depletion HEMT transistors (T1_1, T1_2, T1_N, T2_1, T2_2, T2_N) of the driving circuit are lower than those of the depletion HEMT transistors (T3_1, T3_2, T3_N) of the power circuit.

7. The multi-power supply voltage dc/dc converter block according to one of claims 1-6, **characterized in that** all components of the multi-power supply voltage dc/dc converter block are discrete components mounted on a printed circuit board or connected thereto by connecting wires.

8. The multi-power supply voltage dc/dc converter block according to one of claims 1-6, **characterized in that** all components of the multi-power supply voltage dc/dc converter block are monolithically integrated in an integrated circuit.

9. The multi-power supply voltage dc/dc converter block according to one of claims 1-8, **characterized in that** the HEMT transistors (T3_1, T3_2, T3_N) of the power circuit and the HEMT transistors (T1_1, T1_2, T1_N, T2_1, T2_2, T2_N) of the driving circuit are made of one from gallium nitride (GaN), gallium arsenide (GaAs) or any other semi-conductor material constituted by III-V type materials.

10. The multi-power supply voltage dc/dc converter block according to one of claims 1-9, **characterized in that** the diodes (D1_1, D1_2, D1_N) are Schottky diodes and made of Si, SiC, GaAs, GaN technology or any other semi-conductor material constituted by III-V type materials.

11. A high-frequency and high-power multi-power supply voltage dc/dc converter for the envelope tracking technique, **characterized in that** it comprises a multi-power supply voltage dc/dc converter block according to one of claims 1-10 and an output filter connected to the output of the power circuit of the multi-power supply voltage dc/dc converter block, the filter being preferably constituted by capacitors and inductors, the output of the output filter constituting the output of the high-frequency and high-power multi-power supply voltage dc/dc converter.

12. A high-frequency and high-power multi-power supply voltage dc/dc converter for the envelope tracking technique, **characterized in that** it comprises a multi-power supply voltage dc/dc converter block according to one of claims 1-10, the output of the power circuit of the multi-power supply voltage dc/dc converter block constituting the output of the high-frequency and high-power multi-power supply voltage dc/dc converter.

13. A system for the envelope tracking technique comprising a multi-power supply voltage dc/dc converter for the envelope tracking technique according to claim 11 or claim 12, a RF power amplifier and an envelope tracking processing digital circuit, the envelope tracking processing digital circuit controlling the multi-power supply voltage dc/dc converter and the RF power amplifier, and the output of the multi-power supply voltage dc/dc converter being connected to the power supply voltage input of the RF power amplifier.
